# EUROPÄISCHE PATENTANMELDUNG

(11) **EP 0 917 420 A2**
(43) Veröffentlichungstag der Anmeldung: **19.05.1999**
(21) Anmeldenummer: 98114044.5
(22) Anmeldetag: 28.07.1998
(51) Int. Cl.: H05K 9/00

(54) **Elektronischer Apparat, insbesondere Telefonapparat und Verfahren zu seiner Herstellung**

(30) Priorität: 13.11.1997 DE 19750307
(71) Anmelder: ROBERT BOSCH GMBH, 70442 Stuttgart (DE)
(72) Erfinder: Muench, Volker, 65929 Frankfurt (DE); Lindt, Andreas, 63128 Dietzenbach (DE); Mack, Bernhard, 64521 Gross-Gerau (DE); Daun, Juergen, 55411 Bingen (DE); Kayan, Hasim, 65835 Liederbach (DE); Kaemmerer, Ulrich, 60389 Frankfurt (DE); Hugelschaffner, Roland, 63303 Dreieich (DE); Heilig, Peter, 63322 Rödermark (DE)

(57) **Zusammenfassung**

Ein elektronischer Apparat, insbesondere Telefonapparat, umfassend ein Gehäuse, wenigstens eine auf wenigstens einer in dem Gehäuse angeordneten Trägerplatte vorgesehene elektronische Schaltung und mechanische/elektromechanische Bauteile, die auf der Trägerplatte und/oder an dem Gehäuse angeordnet sind, ist dadurch gekennzeichnet, daß die wenigstens eine Trägerplatte und die mechanischen/elektromechanischen Bauteile einstückig aus einem Kunststoffteil gefertigt sind, in dem elektrische Leitungen und elektrische Komponenten der elektromechanischen Bauteile eingebettet sind.

## Beschreibung

### Stand der Technik

Die Erfindung betrifft zunächst einen elektronischen Apparat, insbesondere einen Telefonapparat umfassend ein Gehäuse, wenigstens eine auf wenigstens einer in dem Gehäuse angeordneten Trägerplatte vorgesehene elektronische Schaltung und mechanische und elektromechanische Bauteile, die auf der Trägerplatte und/oder an dem Gehäuse angeordnet sind.

Derartige elektronische Apparate, insbesondere Telefonapparate sind seit längerem bekannt. In den meisten Fällen sind dabei das Gehäuse, die Trägerplatte, die mechanischen und elektromagnetischen Bauteile sowie weitere Bedienelemente unterschiedliche Bauteile, die durch zum Teil aufwendige Fertigungsverfahren montiert werden müssen.

Es ist daher ein in jüngster Zeit verfolgtes Ziel, derartige elektronischen Apparate so zu gestalten, daß sie möglichst wenig zu montierende Bauteile umfassen. Aus der EP 0 727 932 A2 geht beispielsweise ein Telefonapparat hervor, welcher ein aus zwei Hälften umfassendes Gehäuse aufweist, in dem im montierten Zustand eine Trägerplatte und ein Abschirmelement angeordnet sind. Die Montage erfolgt dabei durch Zusammenfügen der einzelnen Teile.

Seit einiger Zeit existieren räumliche elektronische Baugruppen in Form von räumlichen spritzgegossenen Schaltungsträgern, bei welchen mechanische und elektromechanische Bauteile sowie Leiterbahnen in einer als Spritzgußteil gefertigten Trägerplatte eingebettet sind. Derartige räumliche spritzgegossene Schaltungsträger erübrigen ein Bestücken der Trägerplatte mit mechanischen oder elektromechanischen Bauteilen. Problematisch hierbei ist, daß die auf diese Weise gefertigte Trägerplatte genauso, wie auch bekannte konventionelle Trägerplatten nach Fertigstellung in dem Gehäuse des elektronischen Apparats montiert werden muß und Anschlußverbindungen zwischen der Trägerplatte und weiteren in dem Gehäuse angeordneten Bedienelementen hergestellt werden müssen.

Der Erfindung liegt daher die Aufgabe zugrunde, einen gattungsgemäßen elektronischen Apparat derart weiterzubilden, daß er aus möglichst wenigen Einzelteilen zusammengesetzt ist und auf einfache Weise mit möglichst wenigen Montageschritten herstellbar ist.

### Vorteile der Erfindung

Die Aufgabe wird bei einem elektronischen Apparat der eingangs beschriebenen Art erfindungsgemäß dadurch gelöst, daß die wenigstens eine Trägerplatte und die mechanischen und elektromechanischen Bauteile einstückig aus einem Kunststoffteil gefertigt sind, in dem elektrische Leitungen und elektrische Komponenten der elektromechanischen Bauteile und der Bedienelemente eingebettet sind. Die Ausbildung der wenigstens einen Trägerplatte und der mechanischen und elektromechanischen Bauteile als ein einstückiges Kunststoffteil, in dem die elektrischen Leitungen und elektrischen Komponenten der elektromechanischen Bauteile und der Bedienelemente eingebettet sind, hat den besonders großen Vorteil, daß nicht nur die Trägerplatte auf einfache Weise hergestellt werden kann, sondern daß zusammen mit der Herstellung der Trägerplatte auch gleichzeitig die Herstellung der mechanischen und elektromechanischen Bauteile erfolgen kann, wodurch Herstellungsschritte, die bei konventionellen Trägerplatten entstehen, entfallen. Darüber hinaus umfaßt ein elektronischer Apparat, der auf diese Weise hergestellt ist, weniger Bestandteile, wodurch sich seine Montage erheblich reduziert.

Eine andere, insbesondere hinsichtlich der Reduzierung weiterer Herstellungs- und Montageschritte besonders vorteilhafte Lösung der Aufgabe sieht vor, daß wenigstens ein Gehäuseteil, die wenigstens eine Trägerplatte und die mechanischen/elektromechanischen Bauteile einstückig aus einem Kunststoffteil gefertigt sind, in dem elektrische Leitungen und elektrische Komponenten der elektromechanischen Bauteile eingebettet sind. Bei einem derartigen elektronischen Apparat wird nicht nur wie oben die Trägerplatte und auf ihr ausgebildete mechanische und elektromechanische Bauteile in einem Herstellungsschritt hergestellt, sondern gleichzeitig auch wenigstens ein Teil des Gehäuses, wodurch die separate Herstellung des Gehäuses und die Montage der Trägerplatte in dem Gehäuse entfallen können und die Anzahl der Bestandteile des elektronischen Apparats weiter auf vorteilhafte Weise reduziert wird.

Rein prinzipiell können die elektrischen Leitungen, beispielsweise in Form von Leiterbahnen wie auch die elektrischen Komponenten, beispielsweise Kontaktelemente, auf die unterschiedlichste Art und Weise in dem Kunststoffteil eingebettet sein, so können sie beispielsweise in einer als Trägerplatte vorgesehenen Leiterplatte oder in dem Gehäuse eingebettet sein. Eine besonders vorteilhafte Ausführungsform, die insbesondere auch einen kompakten Aufbau des elektronischen Apparats ermöglicht, sieht vor, daß die elektrische Leitungen und Kontaktelemente der elektromechanischen Bauteile und/oder der Bedienelemente des Apparates sowohl integraler Bestandteil der wenigstens einen Trägerplatte als auch wenigstens einer Gehäusewand sind und wenigstens teilweise in verschiedenen Ebenen angeordnet sind. Beispielsweise können Bedienelemente einer Tastatur sowohl auf der Trägerplatte als auch an einer Gehäusewand vorgesehen sein.

Darüber hinaus kann bei einer insbesondere hinsichtlich der Endmontage vorteilhaften Ausführungsformen vorgesehen sein, daß weitere nicht mit dem Kunststoffteil verbundene Teile, insbesondere Mikrofone und Hörwandler mit den elektrischen Leitungen und/oder elektrischen Komponenten durch eine oder mehrere der folgenden Kontaktierungen elektrisch leitend verbunden sind: Andruck-, Löt-, Schweiß-, Steckverbindungen.

Um eine einfache Montage derartiger, nicht mit dem Kunststoffteil verbundenen Teile zu ermöglichen, ist vorteilhafterweise vorgesehen, daß das Kunststoffteil aus wenigstens zwei das Gehäuse bildenden, miteinander verbindbaren Teilen besteht, durch welche im verbundenen Zustand sämtliche nicht mit dem Kunststoffteil einstückig verbundenen Teile an einer vorgegebenen Position fixiert werden.

Die erfindungsgemäße Aufgabe wird darüber hinaus auch noch durch ein Verfahren zur Herstellung eines elektronischen Apparats, insbesondere eines Telefonapparats, umfassend ein Gehäuse, wenigstens eine auf wenigstens einer in dem Gehäuse angeordneten Trägerplatte vorgesehene elektronische Schaltung und mechanische und elektromechanische Bauteile, die auf der Trägerplatte und/oder dem Gehäuse angeordnet sind, gelöst, bei welchen das Gehäuse, die wenigstens eine Trägerplatte, die mechanischen und elektromechanischen Bauteile sowie die Bedienelemente als einstückiges Spritzgußteil hergestellt werden, in dem die elektrischen Leitungen und elektrischen Kontaktelemente eingebettet werden. Hierdurch wird nicht nur die Herstellung des elektronischen Apparats vereinfacht und dadurch verbessert, es reduzieren sich insbesondere auch die Montageschritte zur Montage eines derartigen elektronischen Apparats, insbesondere eines Telefonapparats, da fast alle elektrischen und elektromechanischen Bauteile bereits in dem Kunststoffspritzgußteil integriert sind.

Was die Einbettung der elektrischen Leitungen, beispielsweise Leiterbahnen, in das Kunststoffspritzgußteil betrifft, so sind rein prinzipiell die unterschiedlichsten Ausführungsformen denkbar.

Eine vorteilhafte Ausführungsform sieht vor, daß die elektrischen Leitungen mittels Heißprägetechnik eingeprägt werden.

Bei einer anderen vorteilhaften Ausführungsform ist vorgesehen, daß man das Kunststoffteil als ein Zwei-Komponenten-Spritzgußteil herstellt und die Leiterbahnen chemisch/galvanisch metallisiert.

Des weiteren kann man in das Kunststoffteil eine leitende Folie einspritzen.

Ferner kann vorgesehen sein, daß man das Kunststoffteil komplett chemisch/galvanisch metallisiert und anschliessend rückätzt. Auf diese Weise können die elektrischen Komponenten und Leitungen ähnlich der Herstellung einer an sich bekannten Leiterplatte erzeugt werden.

### Zeichnung

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: schematisch eine Gehäusewand eines erfindungsgemäßen elektronischen Apparats in Form eines Terminalbodens eines Telefonapparats;
- Fig. 2: eine entlang der Linie II-II in Fig. 1 geschnittene Darstellung des in Fig. 1 dargestellten Terminalbodens;
- Fig. 3: die Ansicht der Bauteileseite einer Trägerplatte, die Teil eines erfindungsgemäßen Apparats ist und
- Fig. 4: die Ansicht der Verdrahtungsseite der in Fig. 3 dargestellten Trägerplatte.

### Beschreibung der Ausführungsbeispiele

Ein elektronischer Apparat, beispielsweise ein Telefonapparat umfaßt ein Gehäuse, welches beispielsweise aus zwei Hälften besteht.

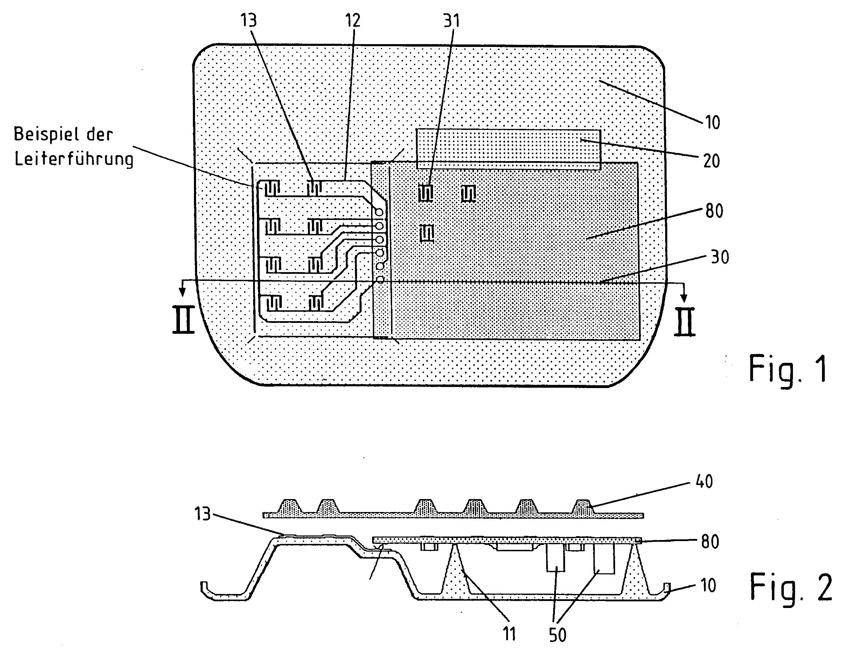

Eine der beiden Hälften, beispielsweise ein Terminalboden 10, wie er in Fig. 1 dargestellt ist, ist als Spritzgußteil hergestellt, in dem elektrische Leitungen in Form von Leiterbahnen und als Kontaktelementen 13 ausgebildete elektrische Komponenten der elektromechanischen Bauteile eingebettet sind. Die Kontaktelemente 13 können beispielsweise Kontaktflächen für Taster einer Tastatur sein (Fig. 1 und 2). Ferner ist in den Terminalboden 10 eine Anzeige 20 integriert, die über in dem Terminalboden 10 integrierte Leiterbahnen sowohl mit den Kontaktflächen der Tasten als auch mit weiteren Bauteilen, die auf einer Trägerplatte 30 angeordnet sind, verbunden sind.

Wie aus Fig. 1 hervorgeht, kann die Trägerplatte 30 als separates Kunststoffspritzgußteil gefertigt sein und ebenfalls Kontaktelemente 31 für eine Tastatur aufweisen, welche genauso wie die Kontaktelemente 13 in dem Terminalboden 10 mittels einer über diesen angeordneten Schaltmatte 40 betätigbar sind.

Die Trägerplatte 30 ist auf an sich bekannte Weise, d.h. durch Löten, Schweißen oder Stecken mit elektrischen oder elektronischen Bauelementen bestückt.

Wie in Fig. 1 und Fig. 2 dargestellt ist, kann der Terminalboden 10 Aufnahmeelemente 11 aufweisen, auf welchen die Trägerplatte 30 aufliegt.

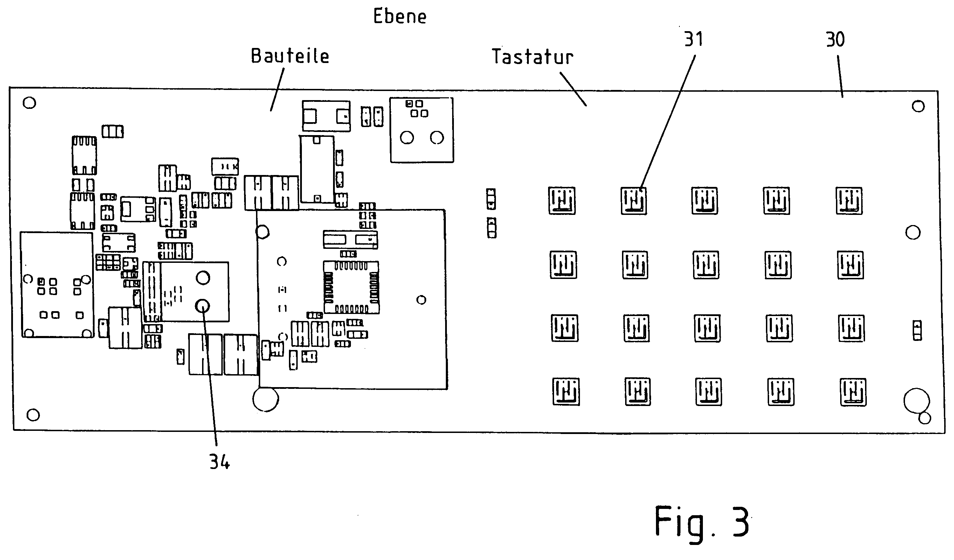

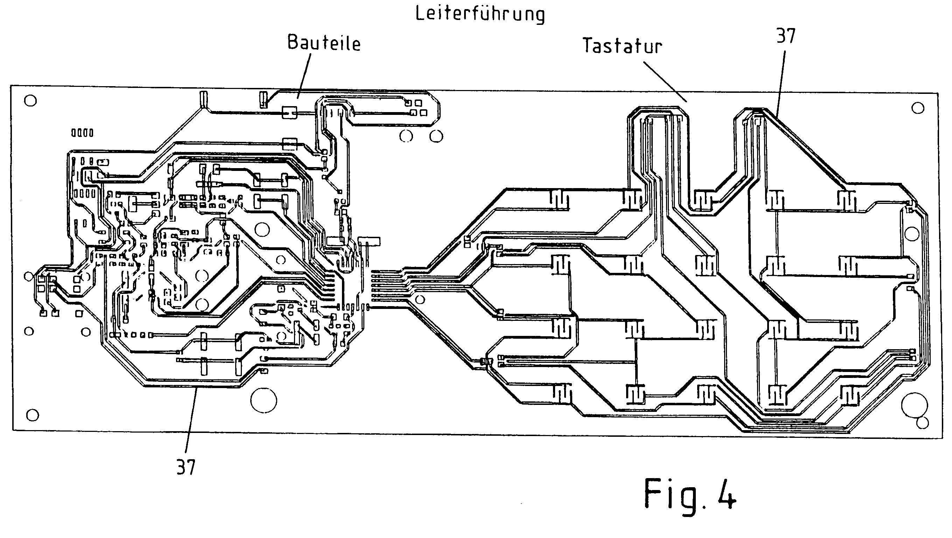

Ein Ausführungsbeispiel einer derartigen Trägerplatte ist in den Fig. 3 und 4 dargestellt. Wie insbesondere aus Fig. 3 hervorgeht, sind mechanische und elektromechanische Bauelemente, beispielsweise Steckverbinder 34 integraler Bestandteil der als Spritzgußteil hergestellten Trägerplatte 30. Darüber hinaus weist die Trägerplatte 30 die in sie eingebetteten Kontaktelemente 31 für eine Tastatur sowie Leiterbahnen 37 (vergl. Fig. 4) auf.

Bei dem in Fig. 1 und 2 dargestellten Ausführungsbeispiel ist die Trägerplatte 30 als separates Kunststoffspritzgußteil dargestellt, welches mit dem Terminalboden 10 verbunden wird. Bei entsprechender Wahl der Bestückung durch die Bauelemente 50 kann darüber hinaus vorgesehen sein, daß der Terminalboden 10 und die Leiterplatte 30 als ein einstückiges Kunststoffspritzgußteil hergestellt sind. In diesem Falle kann der Montageschritt der Befestigung der Trägerplatte 30 an dem Terminalboden 10 vollständig entfallen. Es ist in diesem Falle lediglich die Bestückung des Leiterplattenteils durch die Bauelemente 50 auf an sich bekannte Weise, d.h. durch Löten, Schweißen oder Stecken erforderlich. Hierbei werden sowohl der Terminalboden 10, d.h. eine Gehäusehälfte des Gehäuses des elektronischen Apparats, die Trägerplatte 30 sowie weitere mechanische, elektromechanische Bauteile, die auf der Trägerplatte und/oder dem Terminalboden 10 angeordnet sind, durch einen Spritzgußvorgang hergestellt.

Weitere Teile, beispielsweise Mikrofone oder Hörwandler, die in Fig. 1 und Fig. 2 nicht dargestellt sind, können auf die Trägerplatte 30 und/oder entsprechende Kontaktelemente in einer der beiden Gehäusehälften beispielsweise dem Terminalboden 10 positioniert werden und durch Verbinden des Gehäuseteils in Form des Terminalbodens 10 mit einer weiteren Gehäusehälfte positioniert und in ihrer Lage fixiert werden. Leiterbahnen für diese Teile sind dann vorzugsweise in den Gehäusehälften - wie oben beschrieben - angeordnet. Auf diese Weise reduzieren sich die Montageschritte zum Montieren des gesamten elektronischen Apparats erheblich.

Die Herstellung eines solchen elektronischen Apparats erfolgt dadurch, daß man zunächst wenigstens eine Gehäusehälfte in Form des Terminalbodens 10, die wenigstens eine Trägerplatte 30, die mechanischen und elektromechanischen Bauteile, die auf der Trägerplatte 30 und/oder der Gehäusehäfte angeordnet sind, einstückig aus einem Kunststoffteil fertigt, in dem elektrische Leitungen und elektrische Komponenten der elektromechanischen Bauteile und/oder der Bedienelemente eingebettet werden.

Die Einbettung der elektrischen Leitungen und/oder der elektromechanischen Komponenten erfolgt dabei beispielsweise durch Einprägen mittels Heißprägetechnik oder dadurch, daß man das Kunststoffteil als ein Zweikomponentenspritzgußteil fertigt und die Leiterbahnen und elektrischen Kontaktelemente chemisch/galvanisch metallisiert. Ferner kann in das Kunststoffteil eine leitende Folie eingespritzt werden oder es ist auch möglich, das Kunststoffteil komplett mechanisch/galvanisch zu metallisieren und anschließend die Leiterbahnen und Kontaktelemente durch Rückätzen auszubilden.

Dadurch, daß eine Gehäusehälfte, beispielsweise der Terminalboden 10 und die Trägerplatte 30 als ein Kunststoffspritzgußteil hergestellt sind, welches bereits mechanische und elektromechanische Bauelemente aufweist, können sämtliche bei bekannten elektronischen Apparaten erforderlichen Montageschritte zur Montage und Kontaktierung der Trägerplatte 30 entfallen. Es ist nach Herstellung des Spritzgußteils lediglich noch erforderlich, die Trägerplatte 30 mit den konventionellen elektronischen Bauteilen 50 auf an sich bekannte Weise, d.h. durch Löten, Schweißen oder Stecken zu verbinden. Der Montageaufwand für einen derartigen elektronischen Apparat reduziert sich aufgrund seiner Ausbildung als räumlicher, spritzgegossener Schaltungsträger demnach erheblich.

## Patentansprüche

1. Elektronischer Apparat, insbesondere Telefonapparat, umfassend ein Gehäuse, wenigstens eine auf wenigstens einer in dem Gehäuse angeordneten Trägerplatte (30) vorgesehene elektronische Schaltung und mechanische/elektromechanische Bauteile, die auf der Trägerplatte (30) und/oder an dem Gehäuse angeordnet sind, dadurch gekennzeichnet, daß die wenigstens eine Trägerplatte (30) und die mechanischen/elektromechanischen Bauteile einstückig aus einem Kunststoffteil gefertigt sind, in dem elektrische Leitungen und elektrische Komponenten der elektromechanischen Bauteile eingebettet sind.

2. Elektronischer Apparat, insbesondere Telefonapparat, umfassend ein Gehäuse, wenigstens eine auf wenigstens einer in dem Gehäuse angeordneten Trägerplatte (30) vorgesehene elektronische Schaltung und mechanische/elektromechanische Bauteile, die auf der Trägerplatte (30) und/oder an dem Gehäuse angeordnet sind, dadurch gekennzeichnet, daß ein Gehäuseteil, die wenigstens eine Trägerplatte (30) und die mechanischen/elektromechanischen Bauteile einstückig aus einem Kunststoffteil gefertigt sind, in dem elektrische Leitungen und elektrische Komponenten der elektromechanischen Bauteile eingebettet sind.

3. Elektronischer Apparat nach Anspruch 1 oder 2, dadurch gekennzeichnet, daß die elektrischen Leitungen und elektrischen Komponenten der elektromechanischen Bauteile sowohl integraler Bestandteil der wenigstens einen Trägerplatte (30) als auch wenigstens einer Gehäusewand sind und wenigstens teilweise in verschiedenen Ebenen angeordnet sind.

4. Elektronischer Apparat nach einem der Ansprüche 1 bis 3, dadurch gekennzeichnet, daß weitere, nicht mit dem Kunststoffteil verbundene Teile, insbesondere Mikrofone und Hörwandler mit den elektrischen Leitungen und/oder elektrischen Komponenten der elektromechanischen Bauteile durch eine oder mehrere der folgenden Kontaktierungen elektrisch leitend verbunden sind: Andruck-, Löt-, Schweiß-, Steckverbindungen.

5. Elektronischer Apparat nach Anspruch 4, dadurch gekennzeichnet, daß das Kunststoffteil aus wenigstens zwei, das Gehäuse bildenden und miteinander verbindbaren Teilen besteht, durch welche im verbundenen Zustand sämtliche nicht mit dem Kunststoffteil einstückig verbundenen Teile an einer vorgegebenen Position fixiert werden.

6. Verfahren zur Herstellung eines elektronischen Apparats, insbesondere eines Telefonapparats, umfassend ein Gehäuse, wenigstens ein auf wenigstens einer in dem Gehäuse angeordneten Trägerplatte (30) vorgesehene elektronische Schaltung und mechanische/elektromechanische Bauteile, die auf der Trägerplatte (30) und/oder dem Gehäuse angeordnet sind, dadurch gekennzeichnet, daß wenigstens ein Gehäuseteil, die wenigstens eine Trägerplatte (30) und die mechanischen/elektromechanischen Bauteile als ein einstückiges Spritzgußteil hergestellt werden, in dem die elektrischen Leitungen und elektrischen Komponenten der elektromechanischen Bauteile eingebettet werden.

7. Verfahren nach Anspruch 6, dadurch gekennzeichnet, daß die elektrischen Leitungen mittels Heißprägetechnik eingeprägt werden.

8. Verfahren nach Anspruch 6, dadurch gekennzeichnet, daß man das Kunststoffteil als ein Zwei-Komponenten-Spritzgußteil herstellt und die elektrischen Leitungen/Komponenten chemisch/galvanisch metallisiert.

9. Verfahren nach Anspruch 6, dadurch gekennzeichnet, daß man in das Kunststoffteil eine leitende Folie einspritzt.

10. Verfahren nach Anspruch 6, dadurch gekennzeichnet, daß man das Kunststoffteil komplett chemisch/galvanisch metallisiert und die elektrischen Leitungen/Komponenten durch anschließende Rückätzung herstellt.
